# DEMANDE DE BREVET EUROPEEN

(11) **EP 1 239 291 A1**
(43) Date de publication de la demande: **11.09.2002**
(21) Numéro de dépôt: 02290519.4
(22) Date de dépôt: 04.03.2002
(51) Int. Cl.: G01R 23/16, H04L 27/26

(54) **Procédé de détection de présence d'une fréquence pure ou d'une fréquence modulée linéairement**

(30) Priorité: 05.03.2001 FR 0102966
(71) Demandeur: Sagem S.A., 75015 Paris (FR)
(72) Inventeur: Pintaux, Jean-Bernard, c/o Sagem SA, 75013 Paris (FR)
(74) Mandataire: Fruchard, Guy

(57) **Abrégé**

Procédé de détection de présence d'une fréquence (Fp) à détecter dans un signal analysé, comportant les étapes de :
- échantillonner le signal analysé au moyen d'un signal d'échantillonnage ayant une fréquence (Fe) égale à un multiple (Ne) divisible par quatre de la fréquence à détecter,
- réaliser une transformée de Fourier discrète sur au moins un bloc de quatre échantillons correspondant à une période d'un signal dérivé du signal analysé,
- déterminer à partir de la transformée de Fourier discrète au moins une information en relation avec une amplitude d'au moins une raie sélectionnée du signal échantillonné, et comparer l'information obtenue avec une information correspondante de la fréquence à détecter.

## Description

La présente invention concerne un procédé de détection de présence d'une fréquence pure ou d'une fréquence modulée linéairement.

On sait que préalablement à l'établissement d'une télécommunication il est nécessaire de détecter la présence d'une tonalité, c'est-à-dire un signal à une fréquence pure, ou d'une porteuse que celle-ci soit modulée ou non modulée. Les procédés classiques de détection de présence d'une tonalité ou d'une porteuse, lesquelles seront par la suite dénommées fréquence à détecter, font intervenir un filtrage à bande étroite, résonnant sur la fréquence à détecter ou une fréquence multiple de la fréquence à détecter, suivi d'un dispositif à seuil détectant après filtrage la présence ou l'absence de fréquence à détecter. La détection d'une porteuse modulée linéairement fait par exemple intervenir avant filtrage l'élévation du signal à une puissance paire. Lorsqu'ils sont réalisés sous forme numérique, ces procédés nécessitent l'utilisation de multiplications. Ces procédés sont donc d'une mise en oeuvre lourde impliquant des traitements longs.

Un but de l'invention est de proposer un procédé pouvant être mis en oeuvre sous forme numérique en utilisant seulement des sommations.

En vue de la réalisation de ce but, on propose selon l'invention un procédé de détection de présence d'une fréquence à détecter dans un signal analysé, ce procédé comportant les étapes de :
- échantillonner le signal analysé au moyen d'un signal d'échantillonnage ayant une fréquence égale à un multiple divisible par quatre de la fréquence à détecter,
- réaliser une transformée de Fourier discrète sur au moins un bloc de quatre échantillons correspondant à une période d'un signal dérivé du signal analysé,
- déterminer à partir de la transformée de Fourier discrète au moins une information en relation avec une amplitude d'au moins une raie sélectionnée du signal échantillonné, et comparer l'information obtenue avec une information correspondante de la fréquence à détecter.

Ainsi, le traitement est effectué dans le domaine fréquentiel et le calcul de la transformée de Fourier discrète sur quatre échantillons seulement peut être effectuée sans utilisation de multiplication.

Selon une version avantageuse de l'invention, le procédé comporte les étapes d'effectuer la transformée de Fourier discrète sur plusieurs blocs d'échantillons successifs et de cumuler des résultats relatifs à l'amplitude de la raie sélectionnée, l'information prise en compte pour la comparaison étant la variation du cumul. On élimine ainsi les erreurs de détection résultant d'un bruit parasite incorporé au signal analysé.

D'autres caractéristiques et avantages de l'invention apparaîtront à la lecture de la description qui suit de différents modes de mise en oeuvre particuliers non limitatifs de l'invention, en relation avec les figures ci-jointes parmi lesquelles :
- la figure 1 est un schéma par blocs d'un dispositif numérique mettant en oeuvre le procédé selon l'invention,
- la figure 2 est un schéma par blocs détaillé d'un mode de mise oeuvre d'une partie des étapes de la figure 1,
- la figure 3 est un schéma par blocs analogue à celui de la figure 2 d'une variante de réalisation d'une partie des étapes de la figure 2,
- la figure 4 est un schéma analogue à celui de la figure 1 pour une variante de mise en oeuvre du procédé selon l'invention.

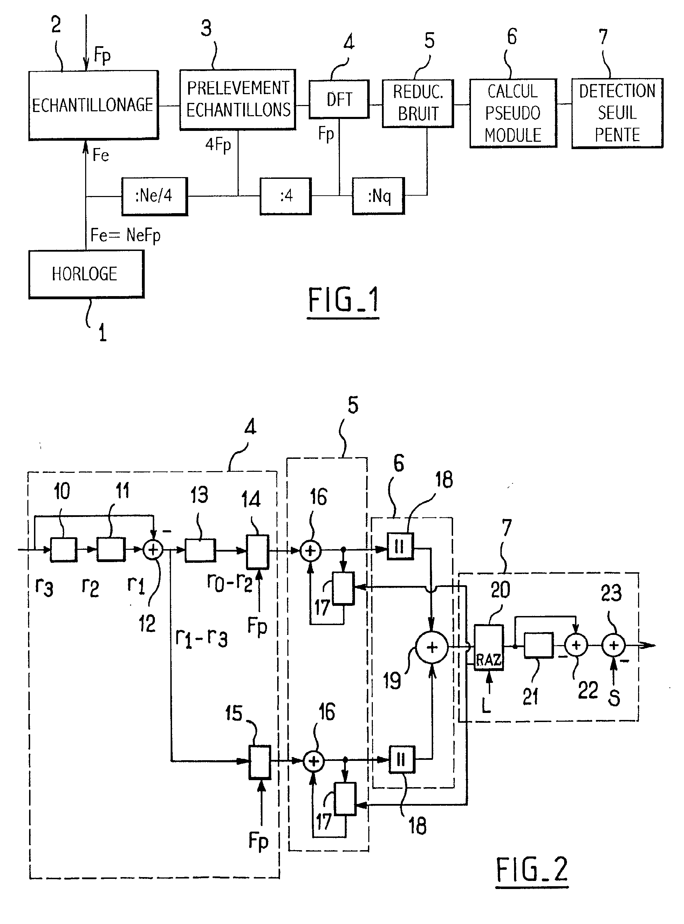

En référence à la figure 1, le dispositif selon l'invention comporte de façon connue en soi une horloge 1 générant un signal d'échantillonnage ayant une fréquence Fe égale à un multiple Ne divisible par quatre de la fréquence Fp à détecter.

Selon l'invention on effectue tout d'abord au moyen de la fréquence d'échantillonnage Fe un échantillonnage 2 du signal analysé dans lequel on cherche à détecter la présence de la fréquence Fp. Dans ce mode de mise en oeuvre, on suppose que la fréquence à détecter est une fréquence pure.

L'échantillonnage 2 est suivi d'une étape de prélèvement 3 de quatre échantillons correspondant à une période du signal analysé. A cet effet la fréquence d'échantillonnage Fe est divisée par le quart du multiple Ne pour obtenir un cadencement de l'étape de prélèvement 3 à une fréquence égale à 4Fp. Les échantillons ainsi prélevés sont utilisés pour une étape de calcul 4 d'une transformée de Fourier discrète DFT. A cet effet, des blocs contenant quatre échantillons sont constitués en effectuant un cadencement de l'étape de calcul 4 à la fréquence Fp.

Dans le mode de mise en oeuvre préféré illustré le bruit éventuellement contenu dans le signal analysé, dont l'amplitude moyenne peut être considérée comme nulle, est réduit lors d'une étape de réduction de bruit 5 en effectuant une accumulation des résultats de la transformée de Fourier discrète sur un nombre Nq de blocs suffisant pour que la moyenne nulle des perturbations puisse être considérée comme sensiblement atteinte. En pratique, l'accumulation des Nq résultats est réalisée en utilisant un signal de cadencement obtenu en divisant par Nq le signal de cadencement de l'étape de calcul 4.

Les résultats ainsi obtenus sont représentatifs de l'amplitude des raies du spectre de raies qui caractérise tout signal périodique dans le domaine fréquentiel.

Un circuit de calcul 6 effectue ensuite un calcul d'un pseudo-module de l'amplitude d'une raie sélectionnée comme il sera indiqué ci-après. L'information ainsi obtenue est comparée dans un module de détection 7 avec une information correspondante de la fréquence à détecter Fp ainsi qu'il sera également indiqué ci-après.

La figure 2 illustre un mode de mise en oeuvre simple de l'étape de calcul de la transformée de Fourier discrète 4, de l'étape de réduction de bruit 5, de l'étape de calcul 6 du pseudo-module et de l'étape de détection 7.

Ainsi qu'il a été indiqué ci-dessus, pour chaque période de la fréquence à analyser, on obtient quatre échantillons r0, r1, r2 et r3. La transformée de Fourier discrète fournit alors quatre raies R0, R1, R2 et R3 parmi lesquelles les raies R1 et R3 sont d'amplitude non nulle dans le cas d'une fréquence pure.

A partir des quatre échantillons prélevés, la raie R1 est définie par un nombre complexe dont la partie réelle est donnée par la différence r0 - r2 et dont la partie imaginaire est donnée par la différence r1 - r3. Un pseudo-module de la raie R1 peut donc être obtenu par de simples sommations comme illustré par la figure 2. A cet effet la transformée de Fourier discrète est réalisée en envoyant les échantillons successivement sur une voie comportant un temporisateur 10 réalisant une temporisation quart de période, c'est-à-dire une temporisation égale au quart de la période correspondant à la fréquence à détecter. La sortie du temporisateur 10 est reliée à l'entrée d'un second temporisateur 11 assurant également une temporisation quart de période et dont la sortie est reliée à une entrée d'un sommateur 12 ayant une seconde entrée inverseuse de signe reliée à l'entrée du temporisateur 10. La sortie du sommateur 12 est reliée d'une part à un temporisateur 13 lui-même relié à un organe de lecture 14 cadencé à la fréquence Fp, et d'autre part directement à un organe de lecture 15 également cadencé à la fréquence Fp.

Lors du déclenchement de la lecture à chacun des organes de lecture 14 et 15, ce déclenchement étant réalisé de façon synchrone avec l'échantillonnage, l'échantillon r3 est présent à l'entrée du temporisateur 10, l'échantillon r2 est présent à l'entrée du temporisateur 11, et l'échantillon r1 est présent à l'entrée du sommateur 12. Compte tenu du décalage assuré par le temporisateur 13, la sortie de celui-ci qui est alors lue par l'organe de lecture 14 est r0 - r2 tandis que l'organe de lecture 15 lit alors la valeur r1 - r3.

Les valeurs qui sont ainsi relevées par les organes de lecture 14 et 15 sont cumulées dans l'étape de réduction de bruit 5 qui comprend pour chaque organe de lecture 14, 15 un circuit comportant un sommateur 16 ayant une première entrée reliée à l'organe de lecture correspondant et une seconde entrée reliée à la sortie d'un temporisateur 17 assurant une temporisation égale à la période correspondant à la fréquence à détecter Fp et dont l'entrée est reliée à la sortie du sommateur 16.

La sortie de chaque sommateur 16 est également reliée à un organe de calcul 18 de la valeur absolue du signal numérique sortant du sommateur 16. Cette valeur absolue est obtenue en détectant le signe de ce signal et en effectuant une inversion de bits appropriée lorsque le signe est négatif. Les valeurs absolues ainsi calculées sont envoyées à un sommateur 19 dont la sortie correspond ainsi à un pseudo-module de l'amplitude de la raie R1 à partir des résultats cumulés dans les boucles d'accumulation 16, 17. Ce pseudo-module est envoyé à un organe de lecture 20 de l'étape 7 de détection de présence de la fréquence à détecter. L'organe de lecture 20 est cadencé à une fréquence L obtenue en divisant la fréquence Fp par le nombre Nq de résultats que l'on souhaite cumuler lors de l'étape de réduction de bruit 5. Par ailleurs l'organe de lecture 20 effectue une remise à zéro des boucles d'accumulation 16, 17 après n lectures, n étant un nombre entier défini pour que les valeurs atteintes dans les boucles d'accumulation 16, 17 soient compatibles avec leur capacité de traitement.

La sortie de l'organe de lecture 20 est reliée d'une part à un temporisateur 21 assurant une temporisation égale à Nq périodes correspondant à la fréquence à détecter Fp, ce temporisateur 21 étant lui-même relié à une entrée inverseuse d'un sommateur 22, et d'autre part à une entrée additionneuse du sommateur 22 par une liaison directe. La sortie du sommateur 22 est reliée à une entrée d'un sommateur 23 ayant une entrée inverseuse recevant un signal de seuil de la pente de variation correspondant à la pente de variation du pseudo-module de la fréquence Fp sur Nq période.

Compte tenu de la structure du circuit de détection 7, l'entrée du sommateur 22 reçoit sur l'entrée directe le pseudo-module cumulé sur n.Nq périodes et sur l'entrée inverse le pseudo-module cumulé sur (n-1)Nq périodes. La sortie du sommateur 22 est donc représentative de la variation, c'est-à-dire la pente, de la sortie de l'accumulateur 16, 17 en relation avec le signal analysé. En comparant cette pente avec un seuil S significatif de la pente d'un signal à la fréquence Fp ne contenant pas de bruit, on détecte la présence ou l'absence de la fréquence à détecter. C'est-à-dire que, si la fréquence à détecter Fp est présente dans le signal analysé, la sortie du sommateur 23 est positive, et si la fréquence à détecter est absente (pente voisine de zéro à l'entrée du sommateur 23) la sortie du sommateur 23 est négative.

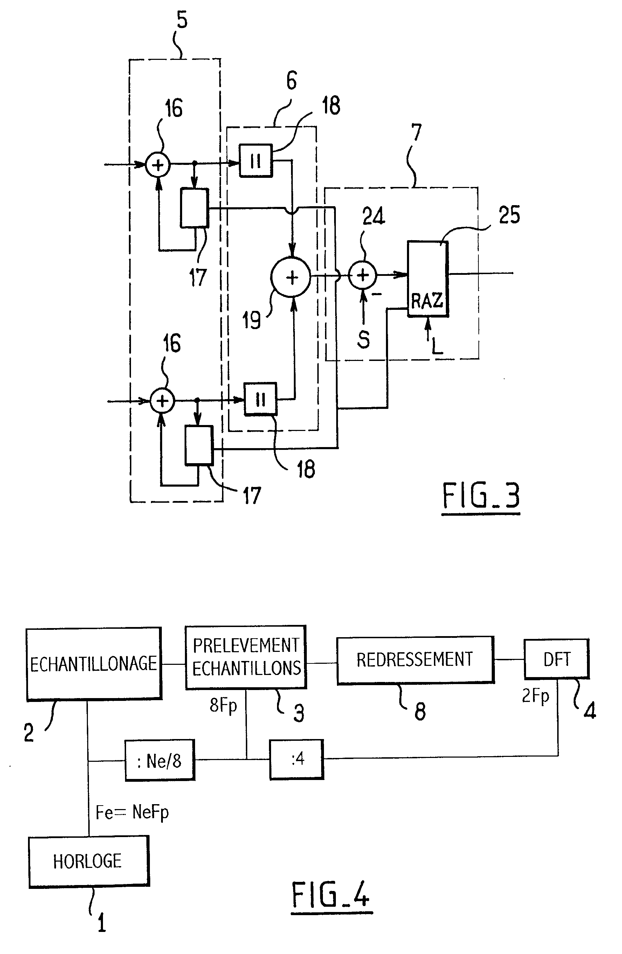

La figure 3 décrit une variante de réalisation dans laquelle un sommateur 24 dont l'entrée inverseuse reçoit le signal de seuil S est directement relié à la sortie du sommateur 19 et sa sortie est reliée à un organe de lecture 25 dont le cadencement est également assuré à la fréquence L. Pour que le signal de sortie de l'organe de lecture 25 soit représentatif de la présence ou de l'absence de la fréquence à détecter, il suffit alors de remettre à zéro la boucle d'accumulation 16, 17 à chaque lecture par l'organe de lecture 25.

La figure 4 illustre une variante de réalisation de mise en oeuvre du procédé selon l'invention particulièrement adaptée à la détection d'une fréquence modulée linéairement. Dans ce cas, la modulation risque d'entraîner une erreur de détection de la porteuse. Pour éviter cette erreur, l'étape 3 de prélèvement d'échantillons est effectuée en divisant le multiple Ne par huit de sorte que le cadencement du prélèvement d'échantillons est effectué à huit fois la fréquence Fp. Une période du signal à la fréquence Fp correspond alors à huit échantillons à la sortie du prélèvement d'échantillons. Un signal dérivé du signal analysé est alors obtenu en effectuant un redressement 8 entre l'étape 3 de prélèvement d'échantillons et l'étape 4 de calcul de la transformée de Fourier discrète. Le redressement 8 effectue une inversion des bits des échantillons négatifs correspondant à une demi-période du signal analysé. Le signal périodique ainsi obtenu a une fréquence double de la fréquence Fp de sorte qu'en effectuant un calcul de la transformée de Fourier discrète avec un cadencement à la fréquence de 2Fp on réalise la transformée de Fourier discrète sur un bloc d'échantillons qui correspond à une période du signal dérivé. La fréquence Fp étant modulée linéairement, la raie R0 est représentative de la composante continue du signal et ne présente pas d'intérêt du point de vue de la mise en oeuvre du procédé selon l'invention, la raie R1 est d'amplitude non nulle et correspond à la fréquence 2Fp, la raie R2 correspond à quatre fois la fréquence Fp et est d'amplitude nulle, et la raie R3 qui correspond à six fois la fréquence Fp est identique à la raie R1.

La détection de présence de la fréquence à détecter peut donc être effectuée de façon analogue à celle décrite en relation avec les figures précédentes, les différents cadencements faisant intervenir la fréquence Fp étant remplacés par des cadencements faisant intervenir la fréquence 2Fp.

Bien entendu, l'invention n'est pas limitée aux modes de mise en oeuvre décrits et on peut y apporter des variantes de réalisation sans sortir du cadre de l'invention tel que défini par les revendications.

En particulier dans le cas où le signal analysé est affecté d'un très faible bruit, on peut supprimer l'étape de réduction de bruit et effectuer une détection de présence de la fréquence Fp sur une période seulement du signal analysé.

Bien que l'invention ait été décrite en utilisant une fréquence d'échantillonnage qui est à un multiple de la fréquence 4Fp, une telle fréquence étant généralement disponible à la sortie du circuit d'horloge pour assurer différents traitements de signaux, le procédé selon l'invention peut être mis en oeuvre avec une fréquence d'échantillonnage directement à la fréquence 4Fp pour une fréquence à détecter pure et à une fréquence 8Fp pour une fréquence à détecter modulée linéairement. Dans ce cas l'étape 3 de prélèvement d'échantillons est supprimée.

## Revendications

1. Procédé de détection de présence d'une fréquence (Fp) à détecter dans un signal analysé, **caractérisé en ce qu'**il comporte les étapes de :
- échantillonner le signal analysé au moyen d'un signal d'échantillonnage ayant une fréquence (Fe) égale à un multiple (Ne) divisible par quatre de la fréquence à détecter,
- réaliser une transformée de Fourier discrète sur au moins un bloc de quatre échantillons correspondant à une période d'un signal dérivé du signal analysé,
- déterminer à partir de la transformée de Fourier discrète au moins une information en relation avec une amplitude d'au moins une raie sélectionnée du signal échantillonné, et comparer l'information obtenue avec une information correspondante de la fréquence à détecter.

2. Procédé de détection selon la revendication 1, **caractérisé en ce qu'**il comporte les étapes d'effectuer la transformée de Fourier discrète sur plusieurs blocs d'échantillons successifs, et cumuler des résultats relatifs à l'amplitude de la raie sélectionnée, l'information prise en compte pour la comparaison étant la variation du cumul.

3. Procédé de détection selon la revendication 1, **caractérisé en ce que** la transformée de Fourier discrète est réalisée par temporisation quart de période des échantillons soumis à la transformée de Fourier discrète et sommation des échantillons temporisés.

4. Procédé de détection selon la revendication 3, **caractérisé en ce qu'**il comporte l'étape de calculer un pseudo-module de l'amplitude en effectuant une sommation de valeurs absolues de parties réelle et imaginaire d'un résultat de la transformée de Fourier discrète.

5. Procédé de détection selon l'une quelconque des revendications précédentes, **caractérisé en ce que** la fréquence d'échantillonnage est égale à un multiple divisible par huit de la fréquence à analyser et le signal échantillonné est redressé avant de réaliser la transformée de Fourier discrète.
